(19) Europäisches Patentamt / European Patent Office / Office européen des brevets

(11) **EP 4 477 619 A1**

(12) **EUROPEAN PATENT APPLICATION**

(43) Date of publication:
**18.12.2024  Bulletin 2024/51**

(21) Application number: **24181320.3**

(22) Date of filing: **11.06.2024**

(51) International Patent Classification (IPC):
**C01B 32/194** *(2017.01)*   **B31D 3/00** *(2017.01)*
**D21F 13/00** *(2006.01)*   **H05K 9/00** *(2006.01)*

(52) Cooperative Patent Classification (CPC):
**C01B 32/194; B31D 3/00; D21F 13/00;
H05K 9/0081;** C01B 2204/20

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **14.06.2023  PL 44520723**

(71) Applicants:
- **POLITECHNIKA WARSZAWSKA**
  **00-661 Warszawa (PL)**
- **SIEC BADAWCZA LUKASIEWICZ - INSTYTUT
  MIKROELEKTRONIKI I FOTONIKI
  02-668 Warszawa (PL)**

(72) Inventors:
- **Marynowicz, Stefan**
  **Warszawa (PL)**

- **Romanowska, Agata**
  **Radom (PL)**
- **Strachowski, Tomasz**
  **Pruszkow (PL)**
- **Racki, Adrian**
  **Warszawa (PL)**
- **Baran, Magdalena**
  **Warszawa (PL)**
- **Ciuk, Tymoteusz**
  **Warszawa (PL)**
- **Yashchyshyn, Yevhen**
  **Lesznowola (PL)**
- **Godziszewski, Konrad**
  **Zabki (PL)**
- **Chlanda, Adrian**
  **Warszawa (PL)**

(74) Representative: **AOMB Polska Sp. z.o.o.
ul. Rondo Ignacego Daszynskiego 1
00-843 Warsaw (PL)**

(54) **GRAPHENE PAPER, METHOD OF PRODUCING REDUCED GRAPHENE PAPER AND USE OF GRAPHENE PAPER**

(57)    The invention concerns graphene paper whose conductivity ranges from 0.00001 to 100 S/cm, wherein the graphene paper consists in 17-55% of oxygen and up to 2% of marginal substances, while the rest is composed by carbon. The invention further concerns the method of producing said graphene paper that comprises the following steps: spreading a graphene paste between substrates, forming the graphene paste spread between two substrates, drying the graphene paste shaped between two substrates, and reduction during which the graphene paper is gradually annealed: at 80-120°C for 24 hours and then at 180-220°C for 24 hours, as well as the use of the produced graphene paper for microwave adsorption.

Fig. 1b

**Description**

The invention concerns graphene paper, in particular graphene paper with a particular conductivity, a method of producing graphene paper, and the use of such paper as a microwave absorber, especially within the range of 50 to 300 GHz.

A growing interest in materials that absorb microwaves is related to their use in various fields, such as medical or laboratory devices. The materials should meet several requirements: they should be thin, lightweight and anticorrosive. However, the priority is to ensure a high absorption in a wide range of frequencies, confirmed by a high total shielding effectiveness ($SE_T$). The desired material should not only reflect but also attenuate the incident electromagnetic waves.

As carbon materials satisfy most of these requirements, they attract a growing interest. In prior art, we know many methods of making graphene materials out of graphene oxide, such as vacuum filtration, press moulding, rGO drying, vortex coating, or spraying, which allow us to produce materials with those required properties.

Hong et al. describe in their publication a prepared graphene paper made by graphene oxide dispersion reduced with hydrochloric acid and poured into a silicone mould to produce samples being 0.102 mm to 0.502 mm thick. The reduction method also covered thermal soaking. The $SE_T$ in this case reached 63.99 dB for a 0.502 mm sample.

The publication by Lan et al. describes a method of producing porous graphene paper with a high electromagnetic shielding effectiveness(SE) being 31.0 dB. The method involved forming composite paper out of graphene oxide and polystyrene by vacuum filtration of a mixed GO and PS suspension though a cellulose filtration membrane.

US2017047139 describes a composition of a film made of graphene oxide, a method of producing such a film, and a method of using it for electromagnetic waves shielding, particularly in the frequency range of 1 GHz to 12 GHz. The composition contains stacked layers of graphene oxide nanoparticles positioned in parallel to the film surface as well as stacked layers of graphene oxide nanoparticles positioned perpendicularly to the film surface. The method of producing the composition involves producing graphene oxide by arc discharge between graphite electrodes in the presence of gaseous oxygen in order to produce a graphene oxide soot, suspending the graphene oxide soot in order to produce colloid, depositing the colloid on the substrate in order to produce wet paper, and drying the wet paper to produce a film. The method of using the composition for screening electromagnetic radiation involves closing and/or encapsulating the source generating the electromagnetic radiation with a free-standing film in order to screen the electromagnetic radiation.

US2013065060 describes graphene paper that contains ordered reduced graphene oxide layers and shows excellent electrical conductivity and mechanical properties, which makes it possible to produce it in large sizes. It can be effectively used for various electrical devices such as thin-film electrodes, flexible electrodes, supercapacitors, or semi-conductive reinforcements of the insulation layer.

CN108966622 discloses a type of microwave absorbing materials with a very wide incidence angle, which consist of an inclined irregular honeycomb structure made of a flexible substrate and a conductive graphene coating applied on a flexible substrate. The invention further discloses a method of producing microwave absorbing materials with a very wide incidence angle. The method comprises steps of structural design of microwave absorbing materials with a very wide incidence angle and generating a distribution of surface resistance by printing out a conductive graphene coating on flexible materials.

However, the present methods of producing graphene paper have many limitations that mostly concern the size of the produced graphene paper, which is limited to the size of the membranes used for vacuum filtration or mould casting. In addition, freely drying graphene paper tends to wrinkle, delaminate and crush. This is why the methods known before require the use of plasticisers that are supposed to minimise these problems.

This invention thus concerns graphene paper with a specified conductivity and chemical composition, produced of graphene oxide, which will not have the said flaws.

The invention concerns graphene paper whose conductivity ranges from 0.00001 to 100 S/cm and that consists in 17-55% of oxygen and up to 2% of marginal substances, while the rest is composed by carbon.

Preferably, the graphene paper is 1 to 25 $\mu$m thick.

Preferably, its total shielding effectiveness ($SE_T$) ranges from 0.1 to 10 dB with the incident wave frequency range of 50 to 300 GHz.

Preferably, its total shielding effectiveness in reference to thickness ($SE_T$) ranges from 20 to 1000 dB/mm with the frequency range of 50 to 300 GHz.

Preferably, its total shielding effectiveness per thickness and density (SSE/t) is within the range of 100 to 6000 dBcm$^2$/g with the frequency range of 50 to 300 GHz.

The invention further concerns a method of producing reduced graphene paper that consists of the following steps:

a) distributing a graphene paste on at least one substrate,
b) pouring the graphene paste distributed on at least one substrate into a thin-film mould,

c) drying the graphene paste formed on at least one substrate,

d) thermal treatment of the graphene paper: at 80-120°C for 24 hours and then at 180-220°C for 24 hours.

Preferably, according to this method, step d) is followed by step e) where the graphene paper is annealed at 280-320°C for 24 hours.

Preferably, according to this method, in step e) the graphene paper is annealed at minimum 300°C.

Preferably, in step d) the graphene paper is annealed at minimum 100°C for 24 hours and then at 200°C for 24 hours.

Preferably, in step a) the graphene paste is applied on the solid or porous substrate with open pores, and then it is covered by the second substrate that is solid or includes open pores.

Preferably, in step a) the graphene paste is dosed by means of a mechanical device that ensures an even thickness of the paste layer and preferably has a nozzle with a longitudinal slot.

Preferably, the graphene paste placed between the two substrates is passed between two cylinders rotating in opposite directions.

Preferably, the drying process in step c) is carried out in the air.

Preferably, according to this method, the graphene paste contains water, alcohol, or organic solvents.

Preferably, according to this method, a graphene paste is used that contains a substance, concentrated at 10 to 60 g/l, selected from a group including graphene oxide, reduced graphene oxide and their derivatives, particularly graphene oxide or reduced graphene oxide functionalised, decorated with metal particles, decorated with metal oxides, wherein it preferably comprises single- or multiple-wall carbon nanotubes, ceramic nanopowder, or nanopowders of metal or metal oxides.

The invention further concerns the use of graphene paper as a microwave absorber, preferably in the range of 50 to 300 GHz.

In another aspect, the invention concerns an electronic device that comprises a microwave absorber comprising graphene paper, such as defined above.

The invention is presented schematically in the drawing wherein:

Fig. 1a is a photo of the graphene paper;

Fig. 1b is a photo of the reduced graphene paper;

Fig. 2 shows the Raman spectrum of the graphene paper and reduced graphene paper according to the invention;

Fig. 3 is a diagram showing the relation between total shielding effectiveness ($SE_T$) and the frequency of the graphene paper and reduced graphene paper according to the invention.

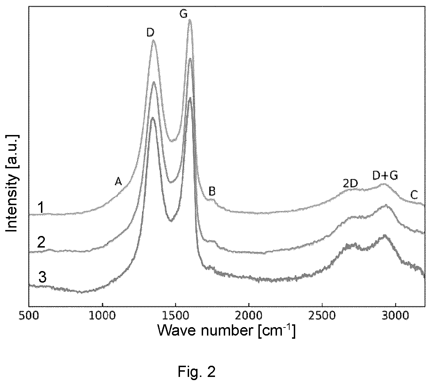

In Fig. 2, we used the following designations: letters D, G, 2D, D+G, A, B and C represent characteristic peaks for graphene oxide in Raman spectroscopy, and the numbers represent the following: 1 - measurement for the graphene paper produced according to example 1, 2 - measurement for the reduced graphene paper produced according to example 2, 3 - measurement for the reduced graphene paper produced according to example 3.

Below we explain the terms used for the present invention:

For the purpose of this invention, "graphene paste" or "paste" or "graphene suspension" mean a mixture that contains a substance, preferably concentrated at 10 to 60 g/l, selected from a group including graphene oxide, reduced graphene oxide and their derivatives, particularly graphene oxide or reduced graphene oxide functionalised, decorated with metal particles, decorated with metal oxides, and any solvent, preferably selected from among water, alcohol, or organic solvent.

For the purpose of this invention, "graphene paper" means a sheet produced of graphene paste with any method, in particular produced with the method according to the invention, containing 45-55% of oxygen and 35-50% of carbon.

For the purpose of this invention, "reduced graphene paper" means a sheet, made of graphene paste, that has been subjected to any method of reduction, in particular thermal reduction.

For the purpose of this invention, "electronic device" means a device in which microwaves are absorbed or isolated. An electronic device can be, for example, an antenna, radar, wave receiver, drone, or aeroplane.

As indicated above, the invention concerns graphene paper with a conductivity of 0.00001 to 100 S/cm, containing 17-55% of oxygen and up to 2% of marginal substances, while the rest is composed by carbon. The graphene paper is free of any additives, including plasticisers, and can be used as a microwave absorber due to its characteristics.

Fig. 2 shows Raman spectra for the graphene paper (line 1) and the reduced graphene paper produced according to example 2 (line 2) and according to example 3 (line 3). The Raman spectroscopy has been carried out by means of a Renishaw InVia spectrometer with a 532 nm laser. The produced spectra have been smoothed, the baselines have been removed, and the data have been normalised.

The key for ensuring such properties is the elemental composition of such paper as well as its thickness. The thickness of the graphene paper according to the invention is below 25 $\mu$m. With these properties, the graphene paper according to the invention shows a very good shielding effectiveness.

The total shielding effectiveness ($SE_T$) is calculated according to the following formula:

$$SE_T = SE_R + SE_A \qquad (1)$$

$SE_R$ in equation (1) was related to reflection, and $SE_A$ was related to the absorption of the incident electromagnetic wave.

The parameters above have been determined on the basis of S-parameters measured with a vector network analyser (VNA) with VDI WR10 frequency extenders and the following equations [12]:

$$T = |S_{21}|^2 = |E_{21s}/E_{21e}|^2 \qquad (2)$$

$$R = |S_{11}|^2 = |E_{11s}/E_{11e}|^2 \qquad (3)$$

for transmission T and reflection R, where E refers to the electrical field, respectively, transmitted by ($E_{21s}$, $E_{21e}$) or reflected from ($E_{11s}$, $E_{11e}$) of the sample and the reference sample.

The absorption coefficient:

$$A_{eff} = (1-R-T)/(1-R) \qquad (4)$$

defined by the foregoing equation defines the effective microwave absorption. The shielding effectiveness parameters were derived from the following equations:

$$SE_R = -10\log_{10}(1 - R) \qquad (5)$$

$$SE_A = -10\log_{10}(1-A_{eff}) \qquad (6)$$

The graphene paper according to the invention is preferably characterised by a shielding effectiveness ranging from 0.1 to 10 dB with the frequency range of 50 to 300 GHz.

In order to include the thickness of the produced layer, we use the SET/t parameter, that is the total shielding effectiveness divided by the thickness of the layer.

The graphene paper according to the invention is preferably characterised by a shielding effectiveness ranging from 20 to 1000 dB/mm with the frequency range of 50 to 300 GHz.

To include the density and thickness of the material, we use the SSE/t parameter defined as follows:

$$SSE/t = SET/\rho/t \qquad (7)$$

Where $\rho$ represents the density of the material and t represents its thickness.

The graphene paper according to the invention is preferably characterised by a total shielding effectiveness, normalised in relation to density and thickness, ranging from 100 do 5800 dBcm$^2$/g with the frequency range of 50 to 300 GHz.

In the second aspect, the invention concerns a method of producing graphene paper. According to this method, a graphene paste, in particular such that contains graphene oxide or reduced graphene oxide or its derivatives (functionalised with metal particles or their oxides), possibly mixed with other materials (nanotubes, ceramics, nanopowders with a specified composition and concentration), is spread and dried between two materials that are hereinafter called substrates. The paste is applied on a substrate that is solid or has open pores, for example a polymer film (the substrate referred to as substrate A). Then the substrate layer is covered by a perforated film or a net with the same mesh size to allow the solvent to evaporate effectively and to prevent the material from leaking out though the net (the substrate referred to as substrate B). In addition, the system is designed in such a way that the paste of graphene material is uniform and distributed between substrates A and B. Finally, the system is left for drying. Dry graphene paper can be easily separated from substrates A and B.

Additionally, in the first step, when the graphene paste is spread between the two substrates, the paste can be dosed with the use of a mechanical device that ensures an even thickness of the paste layer, the device preferably being equipped with a nozzle with a longitudinal slot. It will be particularly preferable to use tape casting, which involves pouring the paste onto a prepared substrate and spreading it with a micrometric applicator. In addition, the paper can preferably be formed by passing the graphene paste between two cylinders rotating in opposite directions.

The drying step is followed by reduction performed by annealing a dried graphene paper. The annealing is carried out gradually, depending on the desired degree of thermal reduction of the graphene paper. The annealing can be performed in any heating device without having to use any complex procedure, which is an additional benefit. The annealing is preferably performed in a laboratory furnace. The reduction is preferably carried out in two steps at 80-120°C, preferably at 100°C for 24 hours, and then at 180-220°C, preferably at 200°C for 24 hours, which can be optionally followed by the third step that involves soaking at 280-320°C for 24 hours, preferably at 300°C.

## Examples

The examples of producing the graphene paper according to the invention use graphene oxide produced with a modified Hummers method [28]. In short, sodium nitrate was dissolved in a 96% sulphuric acid (both purchased at Chempur, Poland), and then we added graphite and continued to mix the solution in a reactor at 30°C. Then we added potassium permanganate (Chempur). Then the mixture was heated up to 55°C and the mixing was continued for several hours. Finally, after dilution with water, hydrogen oxide was added (Chempur, Poland) and the produced graphene oxide was rinsed with deionised water by means of a membrane system.

For all the materials produced, we measured the following parameters.

The thickness of the graphene paper was determined on the basis of images made with a scanning electron microscope (SEM; Phenom ProX).

The density of the graphene paper was determined by adopting the sample thickness determined on the basis of the SEM images (Auriga CrossBeam Zeiss). The area of the discs was assumed at 12 mm and the weight of the discs was measured: they were weighed on a laboratory scale.

The percentage content of oxygen in the produced material was determined by elemental combustion analyzer (LECO O836 analyser).

The specific surface area (SSA) of the graphene papers was determined with the Brunauer-Emmett-Teller (BET) method. The measurements were performed with a Quadrasorb-evo analyser (Quantachrome Instruments).

The electrical properties were tested with the Van der Pauw method (HMS Ecopia 5500) on square samples (10 mm x 10 mm).

### Example 1: Production of graphene paper

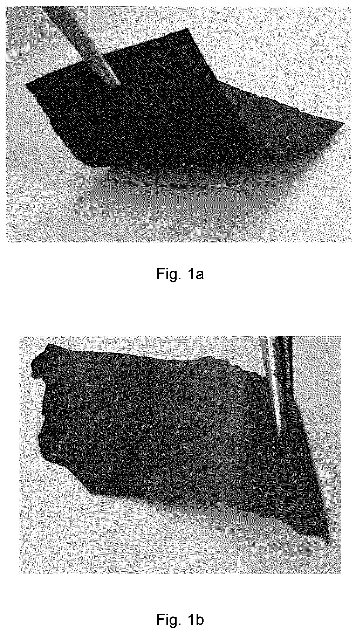

The graphene paper was prepared on a continuous basis with the use of two substrates 1 with different hydrophobicity, forming it between cylinders rotating in opposite directions. Two polymer substrate with a mesh size of 15 mm and a width of 20 cm were introduced into the gap between the two cylinders rotating in opposite directions, being around 100 mm wide. Then a graphene suspension was dosed between the nets. After forming between the cylinders, a suspension was produced that was evenly distributed between the substrates. Then the suspension was evaporated and the paper was separated from the substrates. This method is already known and was described in patent document EP2842910. The graphene paper showed a thickness of 5.03 $\mu$m, density of 2.62 g/cm$^3$, 50.9% oxygen concentration, specific surface area of 2.82 m$^2$/g, and conductivity of 3.58·10$^{-5}$ S/cm. A photo of the graphene paper is shown in Fig. 1a.

### Example 2: Production of reduced graphene paper I

Reduced graphene paper I was produced as in example 1, the difference being that the drying step was followed by thermal reduction for 24 hours at 100°C and then for 24 hours at 200°C. The thermal reduction was carried out in the air atmosphere in a laboratory furnace.

Reduced graphene paper I showed a thickness of 5.64 $\mu$m, density of 0.89 g/cm$^3$, 30.5% oxygen concentration, specific surface area of 4.46 m$^2$/g, and conductivity of 1.46 S/cm.

A photo of the graphene paper is shown in Fig. 2a.

**Example 3: Production of reduced graphene paper II**

Reduced graphene paper II was produced as in example 2, the difference being that another thermal reduction step was added: for 24 hours at 300°C. The thermal reduction was carried out in the air atmosphere in a laboratory furnace.

Reduced graphene paper II showed a thickness of 4.95 $\mu$m, density of 1.1 g/cm$^3$, 22.4% oxygen concentration, specific surface area of 11.45 m$^2$/g, and conductivity of 1.86 S/cm.

**Example 4: Microwave absorption measurements**

The measurements were performed for the materials produced in steps 1, 2 and 3, in the following manner: The method applied is contactless and non-destructive, and the measurements were performed on the delivered sample sheets without having to change their dimensions. The total shielding effectiveness $SE_T$ was determined on the basis of the S parameters measured with a vector network analyser (VNA) with VDI WR10 frequency extenders, in the frequency range of 75-110 GHz and based on formulae (1-6).

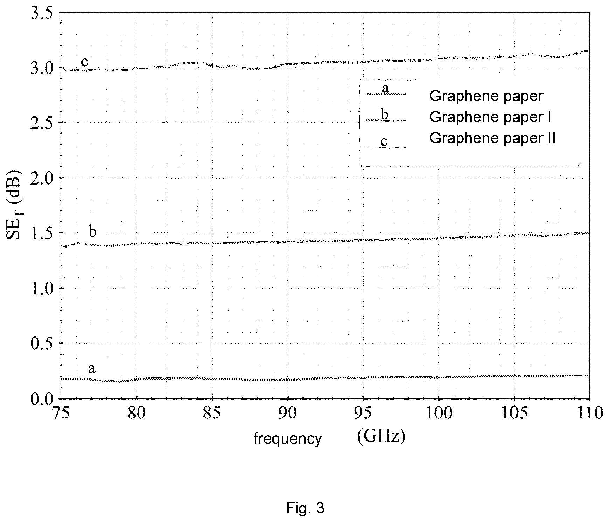

The results of the measurements are presented in the table and Fig. 3 below:

Table 1.

| Material | Thickness [$\mu$m] | $SE_T$ [dB] | $SE_T$/thickness [dB/mm ] | SSE/t [dBcm$^2$/g] | Frequency range [GHz] |
|---|---|---|---|---|---|
| Graphene paper | 5.03 | 0.2 | 40 | 152 | 75-110 |
| Reduced Graphene paper I | 5.64 | 1.5 | 266 | 2976 | 75-110 |
| Reduced Graphene paper II | 4.95 | 3 | 606 | 5510 | 75-110 |

The total shielding effectiveness was increasing along with the reduction degree, from 0.2 dB for the sample of the graphene paper produced according to example 1 to 3 dB for reduced graphene paper II produced according to Example 3. The improved conductivity caused increased losses due to conductivity in the microwave absorption mechanism. Both the increased specific surface area and the formation of pores contributed to multiple reflections. With reference to material thickness, $SE_T$/thickness reached 606 dB/mm.

The obtained ultra-thin, flexible graphene paper according to the invention, designed for absorbing microwaves in a wide range, makes it possible to produce sheets on a large scale. Additionally, the invention ensures a mild, low-temperature, gradual thermal reduction of graphene paper, which was proved by the change in chemical, physical and structural properties: the conductivity and specific surface area were increasing along with the decreasing content of oxygen after reduction. The measurements of microwave absorption properties showed a total shielding effectiveness of around 3 dB in the entire frequency range of 75 to 110 GHz, which is presented in Fig. 3. Therefore, the graphene paper according to the invention can be used as a microwave absorber. The method of producing graphene paper according to the invention makes it easy to adjust and optimise oxygen content and material thickness in order to ensure a satisfactory shielding effectiveness in terms of mechanical properties; the pores formed during reduction provide multiple reflection spots.

**Claims**

1. Graphene paper **characterised in that** it shows a conductivity ranging from 0.00001 to 100 S/cm
wherein the graphene paper consists in 17-55% of oxygen and up to 2% of marginal substances, while the rest is composed by carbon, which is preferably up to 25 $\mu$m thick.

2. The graphene paper according to any of claims 1, **characterised in that** its shielding effectiveness ranges from 0.1 to 10 dB with the frequency range of 50 to 300 GHz.

3. The graphene paper according to any of claims 1, **characterised in that** its shielding effectiveness in reference to thickness ($SE_T$) ranges from 20 to 1000 dB/mm with the incident wave frequency range of 50 to 300 GHz.

4. The graphene paper according to any of claims 1, **characterised in that** its shielding effectiveness per thickness

($SE_T/t$) is within the range of 20 to 1000 dB/mm with the frequency range of 50 to 300GHz.

5. The graphene paper according to any of claims 1, **characterised in that** its shielding effectiveness after normalisation in relation to density and thickness (SSE/t) is within the range of 100 to 5800 $dBcm^2/g$ with the frequency range of 50 to 300 GHz.

6. The method of producing reduced graphene paper according to any of claims 1-5, comprising the following steps:

   a) distributing a graphene paste on at least one substrate,
   b) pouring the graphene paste distributed on at least one substrate into a thin-film mould,
   c) drying the graphene paste formed on at least one substrate,

   **characterised in that** step c) is followed by the reduction step d) where the graphene paper is gradually annealed: at 80-120°C, preferably 100°C, for 24 hours and then at 180-220°C, preferably 200°C, for 24 hours.

7. The method according to claim 6, **characterised in that** step d) is followed by step e) where the graphene paper is annealed at 280-320°C for at least 24 hours, where preferably in step e) the graphene paper is annealed at minimum 300°C.

8. The method according to claims 7, **characterised in that** in step a) the graphene paste is applied on the first substrate that is solid or includes open pores, and then it is covered by the second substrate that is solid or includes open pores.

9. The method according to claim 7, **characterised in that** in step a) the graphene paste (3) is dosed by means of a mechanical device that ensures an even thickness of the paste layer and preferably has a nozzle with a longitudinal slot.

10. The method according to claim 7, **characterised in that** in step a) the graphene paste (3) is spread by passing the graphene paste placed between two substrates between two cylinders rotating in opposite directions.

11. The method according to any of claims 7-10, **characterised in that** the drying process in step c) is carried out in the air.

12. The method according to any of claims 7-11, **characterised in that** the graphene paste is a suspension containing water, alcohol, or organic solvents.

13. The method according to any of claims 7-12, **characterised in that** the graphene suspension used contains a substance, concentrated at 10 to 60 g/l, selected from a group including graphene oxide, reduced graphene oxide and their derivatives, particularly graphene oxide or reduced graphene oxide functionalised, decorated with metal particles, decorated with metal oxides, wherein it preferably comprises single- or multiple-wall carbon nanotubes, ceramic nanopowder, or nanopowders of metal or metal oxides.

14. The use of the graphene paper defined in claims 1-6 as a microwave absorber, preferably in the range of 50 to 300 GHz.

15. An electronic device comprising a microwave absorber comprising the graphene paper according to any of claims 1-6.

Fig. 1a

Fig. 1b

Fig. 2

Fig. 3

Europäisches
Patentamt
European
Patent Office
Office européen
des brevets

**EUROPEAN SEARCH REPORT**

Application Number

EP 24 18 1320

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CRISTINA VALLS ET AL: "Flexible conductive graphene paper obtained by direct and gentle annealing of graphene oxide paper", CARBON, ELSEVIER OXFORD, GB, vol. 50, no. 3, 21 September 2011 (2011-09-21), pages 835-844, XP028343558, ISSN: 0008-6223, DOI: 10.1016/J.CARBON.2011.09.042 [retrieved on 2011-09-29] | 1-5,15 | INV. C01B32/194 B31D3/00 D21F13/00 H05K9/00 |
| A | * page 837, left-hand column, paragraph 3; tables 2-3 * <br> * page 836, right-hand column, paragraph 3-4 * <br> * page 842, paragraph 3 * <br> * the whole document * | 6-14 | |
| X | DONG SHAOHANG ET AL: "Flexible reduced graphene oxide paper with excellent electromagnetic interference shielding for terahertz wave", JOURNAL OF MATERIALS SCIENCE: MATERIALS IN ELECTRONICS, CHAPMAN AND HALL, LONDON, GB, vol. 29, no. 20, 13 August 2018 (2018-08-13), pages 17245-17253, XP036595715, ISSN: 0957-4522, DOI: 10.1007/S10854-018-9818-1 [retrieved on 2018-08-13] | 1-5,14, 15 | TECHNICAL FIELDS SEARCHED (IPC) <br><br> C01B <br> B31F <br> D21J <br> B31D <br> D21F <br> H05K |
| A | * 2.2 preparation of rGO papers; page 17246; figure 3; table 1 * <br> * 1. Introduction; page 17245 * <br> * 4. Conclusions; page 17252 * <br> * the whole document * | 6-13 | |

-/--

The present search report has been drawn up for all claims

| Place of search | Date of completion of the search | Examiner |
|---|---|---|
| The Hague | 25 October 2024 | Follens, Lana |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y,D | EP 2 842 910 A1 (INST TECHNOLOGII MATERIALÓW ELEKTRONICZNYCH [PL]) 4 March 2015 (2015-03-04) | 6-13 | |
| A | * paragraphs [0007], [0021], [0035]; claims 1-15; examples I-V * * the whole document * | 1-5,14, 15 | |
| Y | SHEN YANG ET AL: "Revealing hidden endotherm of Hummers' graphene oxide during low-temperature thermal reduction", CARBON, vol. 138, 10 March 2018 (2018-03-10), pages 337-347, XP093180406, GB ISSN: 0008-6223, DOI: 10.1016/j.carbon.2018.05.018 | 6-13 | |
| A | * 4. Conclusions; page 345 * * the whole document * | 1-5,14, 15 | |
| A | CN 106 413 358 A (HARBIN INSTITUTE TECHNOLOGY) 15 February 2017 (2017-02-15) * the whole document * | 1-15 | TECHNICAL FIELDS SEARCHED (IPC) |

The present search report has been drawn up for all claims

| Place of search | Date of completion of the search | Examiner |
|---|---|---|
| The Hague | 25 October 2024 | Follens, Lana |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 1320

This annex lists the patent family members relating to the patent documents cited in the above-mentioned European search report.
The members are as contained in the European Patent Office EDP file on
The European Patent Office is in no way liable for these particulars which are merely given for the purpose of information.

25-10-2024

| Patent document cited in search report | | Publication date | Patent family member(s) | | Publication date |
|---|---|---|---|---|---|
| EP 2842910 | A1 | 04-03-2015 | EP | 2842910 A1 | 04-03-2015 |
| | | | PL | 2842910 T3 | 31-01-2017 |
| CN 106413358 | A | 15-02-2017 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017047139 A
- US 2013065060 A
- CN 108966622
- EP 2842910 A